Europäisches Patentamt

European Patent Office

Office européen des brevets

(11) Publication number: 0 318 876
A2

# EUROPEAN PATENT APPLICATION

(21) Application number: 88119747.9

(22) Date of filing: 26.11.88

(51) Int. Cl.⁴: H05K 3/38

(30) Priority: 30.11.87 US 126526
28.09.88 US 249353

(43) Date of publication of application:
07.06.89 Bulletin 89/23

(84) Designated Contracting States:
CH DE FR GB IT LI NL

(71) Applicant: E.I. DU PONT DE NEMOURS AND
COMPANY
Legal Department 1007 Market Street
Wilmington Delaware 19898(US)

(72) Inventor: Knight, Alan Campbell
1515 36th Street
Parkersburg, West Virginia 26101(US)
Inventor: McEwen, Craig Steven
401C West Third Street
Wilmington, Delaware 19801(US)

(74) Representative: von Kreisler, Alek,
Dipl.-Chem. et al
Patentanwälte Von Kreisler-Selting-Werner
Deichmannhaus am Hauptbahnhof
D-5000 Köln 1(DE)

(54) Method for improving the adhesion of a metal to a fluoropolymer.

(57) A method is disclosed of adhering copper, aluminum or nickel to a fluoropolymer employing a brass or zinc intermediate layer.

EP 0 318 876 A2

## METHOD FOR IMPROVING THE ADHESION OF A METAL TO A FLUOROPOLYMER

### RELATED APPLICATION

The present application is a continuation-in-part of Serial No. 126,526, Technical Field.

This invention relates to a method for improving the adhesion of metal to a fluoropolymer. In a preferred mode, it relates to a method of increasing the adhesion of copper, aluminum or nickel foils or sheets to fluoropolymer films for use in the production of printed circuit boards.

### Background of the Invention

Conventional printed circuit boards are prepared by laminating metal sheets, e.g., copper sheets, to sheets of electrically insulating materials which have generally been made of epoxy, polyimide or phenolic resin, typically reinforced with glass, or polyimide or polyester films. Typically, a conductor pattern is formed by applying a photosensitive etch-resistant coating to the copper, exposing those areas where the pattern is desired, developing by washing away the unexposed areas, and etching off the unnecessary copper. While the insulating materials above are satisfactory for many applications, these materials have high dielectric constants. For applications in which high frequencies are used, very rapid rise times are required, or signal propagation delay must be reduced, performance would be improved by the use of insulating materials with lower dielectric constants. It is well known that perfluorinated polymers, such as polytetrafluoroethylene, copolymers of tetrafluoroethylene and hexafluoropropylene, and copolymers of tetrafluoroethylene and perfluoro(propyl vinyl ether), and the like, are suitable for use in printed circuit boards because of their low dielectric constant. In addition, laminar structures are available which have a perfluorinated polymer on the outer surface and different polymeric materials on the inner side, e.g., polyimide coated with fluoropolymers. However, these materials suffer the disadvantage that it is extremely difficult to obtain a strong bond between the fluoropolymer and the metal conductor.

The prior art is replete with examples of attempts to improve the adhesion between fluoropolymers and metals. In Purvis et al., U.S. Pat. No. 2,789,063, the surface of polytetrafluoroethylene (PTFE) is activated to improve adhesion by reacting it with suitable fluid metals. Fluid metals are defined as those in a free-flowing state, such as vapor or molten liquid, so that finely-divided mobile metallic particles contact the fluorocarbon surface, as opposed to a solid metal mass. Suitable metals are those more electropositive than zinc. Allen et al., U.S. Pat. No. 2,955,974, obtain improved adhesion by laminating (1) a layer of copper having an oxide bonding layer, (2) a thin solid layer of fluorocarbon resin and (3) a sheet of a porous material, such as glass cloth, which is partially embedded in the surface of the fluorocarbon resin layer. Hochberg. U.S. Pat. No. 3,136,680, discloses a copper/PTFE laminate with improved adhesion in which the copper is coated with cadmium, nickel, tin or alloys thereof, and an intermediate layer of a tetrafluoroethylene/hexafluoropropylene copolymer (FEP) is used as an adhesive. Eggleton, U.S. Pat. No. 3,304,221, uses an intermediate adhesive layer of particulate PTFE to bond PTFE film to metallic substances. Adams, U.S. Pat. No. 3,486,961, discloses a laminate with improved adhesion in which an unsintered fibroid porous PTFE film, an FEP film and a metallic substrate are passed through heated rolls which sinter the PTFE and melt the FEP, bonding the fluoropolymer composite to the substrate. Tally et al., U.S. Pat. No. 3,767,500, disclose a method of laminating plastic films, which may be fluoropolymers, to metals by winding long strips of these materials into a roll and heating them for relatively long periods of time while they are under pressure in the roll. Erwin. U:S. Pat. No. 3,837,956, discloses a method of bonding fluoropolymer films to metal surfaces in a near perfect vacuum environment. Suzuki, U.S. Pat. No. 4,640,866, discloses a method of improving the adhesion by using a PTFE layer which contains fibers of porous, expanded, sintered PTFE mixed within it, or one which has a layer of porous, expanded, sintered PTFE bonded to the opposite side. Gazit et al., U.S. Pat. No. 4,647,508, disclose a method for improving the adhesion between a fluoropolymer coated polyimide and a copper conductive pattern in which a microglass reinforced fluoropolymer layer is used as an adhesive. While all of these methods improve the adhesion of metals to fluoropolymers to some degree, some of the improvements are only marginal and the adhesion is not sufficient for printed circuit board applications. Others require the addition of adhesive materials which are difficult to apply. Still others involve the use of expensive and time-consuming methods. It is desired to have a method for firmly bonding metalic sheets to fluoropolymer films or laminates which is inexpensive and easy to use and employs commercial or readily available materials.

## SUMMARY OF THE INVENTION

The present invention is directed to a method for adhering a metal to a fluoropolymer employing an intermediate layer comprising contacting a metal selected from the group consisting of copper, aluminum and nickel, a layer of zinc or brass and a fluoropolymer which is selected from the group consisting of polytetrafluoroethylene, a copolymer of tetrafluoroethylene and hexafluoropropylene, a copolymer of tetrafluoroethylene and perfluoro(propyl vinyl ether), a copolymer of tetrafluoroethylene and perfluoro-2,2-dimethyl-1,2-dioxole, a terpolymer of tetrafluoroethylene, hexafluoropropylene and perfluoro(propyl vinyl ether), and a terpolymer of tetrafluoroethylene, hexafluoropropylene and perfluoro(ethyl vinyl ether), whereby the zinc or brass is between the fluoropolymer and the metal and during the contacting a temperature is employed from the melting point of the fluoropolymer to below the the decomposition temperature of the fluoropolymer with the proviso that at least one of the following is obtained in accordance with the Test Method No. 2.4.9, Revision A, Method B of the Institute for Interconnecting and Packaging Circuits:

(i) a value of at least 3.0 pounds per linear inch or

(ii) an increase in adhesion of at least 40 percent compared to an article formed in which the zinc or brass intermediate layer is eliminated and the metal is directly bonded onto the fluoropolymer.

## DETAILED DESCRIPTION OF THE INVENTION

Excellent metal-fluoropolymer bonds are obtained by using the technique disclosed herein. In accordance with the present invention, a durable metal-fluoropolymer laminate is obtained by placing a layer of zinc or brass between a metal, preferably a foil, and a perfluorinated polymer, preferably a film, and using a temperature at or above the melting point of the fluoropolymer, but below the decomposition temperature of the fluoropolymer. Temperatures below, at or above the melting point of the zinc or brass may be employed which are below the decomposition temperature of the fluoropolymer.

A preferred metal for use in practicing the invention is copper. A preferred way to obtain the layer of zinc or brass is to coat the copper with zinc or brass prior to applying it to the fluoropolymer film. The thickness of the zinc or brass coating and the thickness of the total metal is not particularly critical and depends on the final use for the material. For printed circuit board applications, total thicknesses of about 0.0014 inch (0.0036 cm) to about 0.0028 inch (0.0071 cm) are generally used. This corresponds to a thickness by weight of 1 to 2 ounces per square foot (305 to 610 grams per square meter). Most metal foils are identified by their weight alone, e.g., one-ounce copper foil. The thickness of the zinc or brass coating should be at least about 0.03 microns. It is preferably 0.1 to 0.2 microns, but may be thicker. With copper and zinc employed, a brass layer may be formed due to the use of elevated temperature. Therefore with starting materials of copper and zinc either zinc or brass may be present to contact the fluoropolymer layer.

The method of applying the zinc or brass to the copper is also not critical. Generally these materials are produced by electroplating. First, electrodeposited copper can be produced by plating onto a stainless steel drum, from which the copper is continuously stripped. The inner surface of the resulting material exhibits a smooth finish, whereas the outer surface is coarse. Then a zinc or brass coating is electroplated directly onto the copper, usually onto the coarse surface. The zinc coating can be converted to brass by the spontaneous diffusion of copper and zinc during a high temperature lamination step. Alternatively, rolled-annealed copper can be produced by alternately cold-rolling and annealing cast copper ingots. One of the surfaces may be treated by electrodepositing copper to coarsen the surface before electroplating with zinc or brass as in the case of electrodeposited foil. Zinc-coated copper foils prepared in this way are commercially available from Yates Industries (Bordentown, NJ) under the product name TW. Brass-coated copper foils prepared in this way are commercially available from Gould, Inc. (Eastlake, OH) under the product name JTC. It is also possible to apply a zinc coating to copper by evaporative techniques, such as sputtering, electron beam evaporation, and the like.

Although the process of the present invention is particularly useful for bonding zinc- or brass-coated copper to a fluoropolymer for printed circuit board applications, other metals may be employed in the process of the present invention. Zinc-coated aluminum or zinc-coated nickel may be substituted for the zinc-coated copper depending on the use of the final product.

In the present invention, a zinc layer when employed with copper may be converted to brass such that brass is present and contacts the fluoropolymer. However, the zinc layer can be of sufficient thickness that zinc contacts the fluoropolymer.

It is also possible to use a zinc or brass layer without previously coating it onto the metal to be adhered to the fluoropolymer film. In this case, a zinc or brass metal foil is placed between the fluoropolymer and the other metal such as a foil of copper, aluminum or nickel and this three-layer structure is treated at an elevated temperature as described above. The thickness of the zinc or brass is not particularly critical, but it should be generally kept as thin as possible. Zinc or brass foil is commercially available in thicknesses from 0.0005 inch (0.0013 cm) to one inch (2.54 cm) or more. It is preferred that the thickness be less than 0.001 inch (0.0025 cm).

The fluoropolymers which are useful in the invention are any perfluorinated polymers which can be provided in the form of a film or sheet and which have a melting point less than the melting point of zinc. Suitable fluoropolymers include polytetrafluoroethylene (PTFE); copolymers of tetrafluoroethylene and hexafluoropropylene (FEP) as described in U.S. Pat. No. 2,946,763; copolymers of tetrafluoroethylene and perfluoro(propyl vinyl ether) (PFA) as described in U.S. Pat. No. 3,132,123; copolymers of tetrafluoroethylene and perfluoro-2,2-dimethyl-1,2-dioxole as described in U.S. Pat. No. 4,530,569; and terpolymers of tetrafluoroethylene, hexafluoropropylene and either perfluoro(propyl vinyl ether) or perfluoro-(ethyl vinyl ether) as described in U.S. Pat. No. 4,029,868.

It is known to use fluoropolymer films alone as the dielectric material and also to use polyimide film covered on one or both sides with fluoropolymer film. The polyimide film is used because of its low coefficient of thermal expansion and high modulus, as well as its acceptable dielectric constant. The polyimide/fluoropolymer laminate is less apt to exhibit distortion during the stress of processing than is the fluoropolymer laminate alone. Polyimide film coated on one or both sides with FEP is commercially available as Kapton® F polyimide (E. I. du Pont de Nemours and Company, Wilmington, DE). Polyimide film coated on one or both sides with PFA is commercially available as Kapton® XP polyimide (E. I. du Pont de Nemours and Company, Wilmington, DE). The polyimide film may also be coated with polytetrafluoroethylene.

In practicing one embodiment of the method of the present invention a fluoropolymer film or polyimide/fluoropolymer film is placed in contact with the zinc or brass side of a zinc- or brass-coated metal foil. Alternatively, a fluoropolymer/zinc or brass foil/metal foil structure is put together. Either one of these layered structures is then laminated with heat for a time sufficient to ensure a strong bond. The temperature used should be in the range between the melting point of the fluoropolymer and the decomposition temperature of the fluoropolymer. Within this range temperatures below the melting point of zinc or brass represent a preferred embodiment. The melting point of zinc is 788° F (420° C). The melting point of brass depends on the atomic per cent of zinc in the brass and varies from near 788° F (420° C) for brass with a high percentage or zinc to near 1980° F (1083° C) for brass with a low percentage of zinc. It is preferred that the temperature not exceed the melting point of zinc. A most preferred temperature range is 650 to 750° F (370 to 400° C) when the fluoropolymer is PTFE or PFA; 600 to 650° F (315 to 345° C) when the fluoropolymer is the lower melting FEP. It will be recognized by those skilled in the art that the melting point of some fluoropolymer films can vary depending upon the method of preparation, ratio of constituents, etc. Therefore it will be necessary to adjust the laminating temperature to the particular physical properties of the film being used.

It is not necessary to use any pressure other than atmospheric pressure during the lamination step. However, it is preferred that the pressure be at least 25 psi. Pressures of 100 to 300 psi are particularly preferred. The time of lamination must be adjusted according to the other parameters used. Generally, a lamination time of about 30 to 60 minutes is adequate.

In practicing a second embodiment of the method of the present invention a fluoropolymer film or polyimide/fluoropolymer film is placed in contact with the zinc or brass side of a coated metal foil. Alternatively, a fluoropolymer/zinc or brass foil/metal foil structure is put together. Either one of these layered structures is then subjected to a vacuum lamination step. The vacuum lamination technique used may be either vacuum autoclave lamination (VAL) or vacuum hydraulic lamination (VHL). When VAL is used the layered structure is placed on a carrier tray equipped with vacuum hookups. This forms the vacuum assembly. The most common VAL method used for applying a vacuum consists of placing a flexible membrane over the layered structure, sealing at the edges and then drawing a vacuum. The vacuum assembly is then transferred into a pressure vessel which is also sealed. The vessel is then pressurized with inert gas and heated to the desired lamination temperature. When VHL is used a similar vacuum assembly is used and placed into the opening of a static hydraulic press. The thermal input is through the

4

platens of the press. The temperature, pressure, and time requirements are the same as those discussed above for standard lamination techniques.

It will be clear to those skilled in the art that the metal can be laminated to both sides of the fluoropolymer or polyimide/fluoropolymer to prepare double-sided circuits. In addition, more than one such circuit bearing sheet can be combined in layers with bonding or adhesive interlayers between them to form multilayer constructions.

In the present technique the zinc or brass initially contacts the fluoropolymer as a solid metal mass which is not true of Purvis et al. USP 2,789,063 which employs vapor contact.

The adhesion of the resulting metal/fluoropolymer interface can be measured by well-known testing procedures using an Instron test instrument. A suitable test procedure is in accordance with Test Method No. 2.4.9, Revision A, Method B of the Institute for Interconnecting and Packaging Circuits. The absolute value of the adhesion obtained will vary with the composition of the fluoropolymer and the conditions used. However, when conditions are optimized an adhesion value of about at least 12 pounds per linear inch is achievable with most fluoropolymers. In all cases the adhesion in accordance with this test method will be at least 3.0 pounds per linear inch (536 grams per linear meter). A preferred adhesion value is at least 6.0 pounds per linear inch (1071 grams per linear meter); a most preferred adhesion value is at least 9.0 pounds per linear inch (1607 grams per linear meter). However, the adhesion will be greater with zinc- or brass-coated metals when compared to the same fluoropolymer and the metal without the zinc or brass. In general the adhesion of copper, aluminum or nickel to fluoropolymers does not exceed 2.0 pounds per linear inch (357 grams per linear meter) when laminated together. The percent increase in adhesion is greater than 40 percent and usually greater than 200 percent in comparison to a similar article formed by lamination without the intermediate brass or zinc layer.

The following examples illustrate the temperature and pressure dependence of the fluoropolymer/zinc lamination step and the superior adhesion obtained when zinc is present between the copper layer and the fluoropolymer layer.

Example 1

A 5-mil (0.013 cm) thick film of Teflon® TFE (Dixon Industries Corp., Bristol, RI) was sandwiched between two sheets of 1 ounce rolled-annealed JTC brass-treated copper foil (Gould Inc., Eastlake, OH). This was placed in a laminating press, model MTP-14 (Tetrahedron Associates, Inc., San Diego, CA). The temperature of the press was brought up to the peak temperature indicated at 25° F/minute (14° C/minute), held there for 30 minutes, and then cooled to below 100° F at 50° F/minute (38° C at 28° C/minute). The pressure was maintained throughout the cycle at either 100 psi or 300 psi as indicated. The resulting adhesion was measured using an Instron testing instrument (Instron Corp., Canton, MA) according to Test Method No. 2.4.9, Revision A, Method B of the Institute for Interconnecting and Packaging Electronic Circuits. As a control, the procedure was repeated using 1 ounce rolled-annealed oxide-treated copper foil (Oak Industries, Hoosick Falls, NY). The results are given in Table 1.

Table 1

| | Adhesion (pounds/linear inch) | | | |
| | 100 psi | | 300 psi | |
| | brass/Cu | control | brass/Cu | control |
|---|---|---|---|---|
| 750° F (399° C) | 7.9 | 1.9 | 12.6 | 1.8 |
| 700° F (371° C) | --- | --- | 9.9 | 1.6 |
| 650° F (343° C) | 5.4 | --- | 5.2 | 1.3 |
| 600° F (316° C) | --- | --- | 1.1 | 0 |
| 550° F (288° C) | 0 | --- | 0.4 | --- |

Example 2

The procedure in Example 1 was repeated except that the Teflon® TFE film was replaced with 5-mil (0.013 cm) thick Teflon® PFA film (E. I. du Pont de Nemours and Company, Wilmington, DE). The results are given in Table2.

Table 2

| | Adhesion (pounds/linear inch) | | | |
| --- | --- | --- | --- | --- |
| | 100 psi | | 300 psi | |
| | brass/Cu | control | brass/Cu | control |
| 750°F (399°C) | 12.4 | 1.6 | 11.6 | 1.6 |
| 700°F (371°C) | --- | --- | 10.2 | 1.7 |
| 650°F (343°C) | 6.0 | --- | 6.6 | 1.5 |
| 600°F (316°C) | --- | --- | 5.5 | 2.0 |
| 550°F (288°C) | 0 | --- | 0.5 | --- |

Example 3

The procedure in Example 1 was repeated except that the Teflon® TFE film was replaced with 5-mil (0.013 cm) thick Teflon® FEP film (E. I. du Pont de Nemours and Company, Wilmington, DE). The results are given in Table 3.

Table 3

| | Adhesion (pounds/linear inch) | | | |
| --- | --- | --- | --- | --- |
| | 100 psi | | 300 psi | |
| | brass/Cu | control | brass/Cu | control |
| 750°F (399°C) | 5.2 | 1.8 | 7.2 | 1.9 |
| 700°F (371°C) | --- | --- | 11.2 | 2.5 |
| 650°F (343°C) | 12.3 | 1.6 | 12.1 | 2.1 |
| 600°F (316°C) | --- | --- | 11.5 | 2.1 |
| 550°F (288°C) | 4.8 | 2.7 | 6.2 | 1.9 |
| 500°F (260°C) | --- | --- | 1.4 | 1.3 |

Example 4

The procedure in Example 1 was repeated except that the Teflon® TFE film was replaced with a 6-mil (0.015 cm) thick film produced by the copolymerization of tetrafluoroethylene and perfluoro-2,2-dimethyl-1,2-dioxole as described in U.S. Pat. No. 4,530,569. Also rolled-annealed JTC brass-treated copper foil was replaced by a 1 ounce electrodeposited JTC brass-treated copper foil (Gould Inc., Eastlake, OH). The peak temperature was 610°F (321°C) and the pressure was 300 psi. As before, the procedure was repeated using 1-ounce rolled-annealed oxide-treated copper foil as a control. The results are given in Table 4.

Table 4

| Cu Foil | Adhesion (pounds/linear inch) |
|---|---|
| ED brass/Cu | 7.2 |
| control | 3.8 |

Example 5

This example illustrates the use of zinc-treated copper foil. The procedure in Example 1 was repeated except that the fluoropolymer films were sandwiched between two sheets of 1-ounce electrodeposited zinc-treated copper foil (Yates Industries, Inc., Bordentown, NJ). When the fluoropolymer film was Teflon® TFE, the peak temperature use was 680° F (360° C) and the pressure was 220 psi. When the fluoropolymer film was Teflon® PFA or Teflon® FEP the peak temperature was 650° F (343° C) and the pressure was 275 psi. The results are given in Table 5..

Table 5

| Fluoropolymer | Adhesion (pounds/linear inch) | |
|---|---|---|
| | zinc/Cu | control |
| Teflon® TFE | 5.9 | 2.1 |
| Teflon® PFA | 10.9 | 1.8 |
| Teflon® FEP | 20.8 | 2.0 |

Example 6

This example illustrates the improved adhesion between polyimide/fluoropolymer films and brass-treated copper foil. Samples of 2-mil (0.005 cm) thick Kapton® F and Kapton® XP film were laminated to the following 1-ounce copper foils: rolled-annealed brass-coated copper foil (RA brass/Cu), electrodeposited brass-coated copper foil (ED brass/Cu) and oxide-treated copper foil (control) using the procedure given in Example 1. The temperature used was 650° F (343° C) and the pressure was 300 psi. The results are given in Table 6. In all cases the brass-treated copper laminate failed at the Kapton®-fluoropolymer interface so that the bond strength of the copper/brass-fluoropolymer interface is actually higher than what is given below.

Table 6

| Cu Foil | Adhesion (pounds/linear inch) | |
|---|---|---|
| | Kapton® F | Kapton® XP |
| RA brass/Cu | >5.4 | >5.9 |
| ED brass/Cu | >6.8 | >7.8 |
| control | 2.1 | 4.2 |

Example 7

This example illustrates the unique ability of zinc to adhere to fluoropolymer films. The procedure in Example 1 was repeated at 300 psi using as fluoropolymer films Teflon® PTFE, Teflon® PFA and Teflon® FEP, and as metal foils 1-ounce nickel-coated copper foil (Gould, Inc., Eastlake, OH) and the copper and brass/copper foils described in Example 1. For PTFE the lamination temperature was 700°F (371°C): for PFA and FEP the lamination temperature was 650°F (343°C). The results are compared with the results using copper and brass/copper in Table 7.

Table 7

| | Adhesion (pounds/linear inch) | | |
|---|---|---|---|
| Metal Foil | PTFE | PFA | FEP |
| Cu | 1.6 | 1.5 | 2.1 |
| Ni/Cu | 2.7 | 1.9 | 3.3 |
| brass/Cu | 9.9 | 6.6 | 12.1 |

Example 8

This example illustrates the improved adhesion of metals other than copper to fluoropolymer films using a zinc coating layer. A coating of zinc approximately 0.15 microns thick was electron-beam evaporated onto nickel foil and aluminum foil by Thin Film Technology, Inc. (Buellton, CA). A 5-mil (0.013 cm) thick film of Teflon® TFE was laminated to these samples using the procedure in Example 1 with a peak temperature of 700°F (371°C) and a pressure of 300 psi. The results are given in Table 8.

Table 8

| | Adhesion (pounds/linear inch) | |
|---|---|---|
| Metal | Zn/metal | Metal alone |
| Al | 1.9 | 1.3 |
| Ni | 2.8 | 0.5 |

Example 9

This example illustrates the use of vacuum autoclave lamination (VAL). A layered structure of Kapton® XP and rolled-annealed brass-treated copper foil was prepared as in Example 6 except that the laminating press was replaced by a vacuum autoclave, model 512 (Baron Autoclave Corp., Santa Fe Springs, CA). The temperature of the autoclave was brought up to 650°F (343°C) at 15°F/minute (8°C/minute), held there for 30 minutes, and then cooled to below 100°F at 7.5°F/minute (38°C at 4°C/minute). The pressure was maintained throughout the cycle at 200 psi using nitrogen gas. The vacuum assembly was maintained at 28.5 inches mercury. The result is shown in Table 9 compared with laminates of Kapton® XP and rolled-annealed brass-treated copper foil and of Kapton® XP and oxide-treated copper foil, both produced in a laminating press. As before, the brass-treated copper laminates failed at the Kapton®-fluoropolymer interface so the bond strength of the copper/brass-fluoropolymer interface is actually higher than what is given below.

Table 9

| Cu Foil | Lamination | Adhesion (pounds/linear inch) |
|---|---|---|
| RA brass/Cu | autoclave | >7.6 |
| RA brass/Cu | press | >5.9 |
| control | press | 4.2 |

Example 10

This example illustrates the use of a separate zinc metal foil placed between the copper foil and fluoropolymer film. A 5-mil (0.013 cm) thick film of Teflon® TFE was placed in contact with a sheet of 2-mil (0.005 cm) thick zinc foil (Surepure Chemetals, Florham Park, NJ). This was then laminated together with a sheet of 1-ounce rolled-annealed oxide-treated copper foil on the side facing the zinc foil and a sheet of 1-ounce electrodeposited zinc-treated copper foil on the side facing the Teflon® TFE. The procedure in Example 1 was used with a peak temperature of 680° F (360° C) and a pressure of 300 psi. Adhesion was determined at the zinc foil/Teflon® TFE interface. The result (Zn/Cu) is given in Table 10, compared with a laminate of Teflon TFE and oxide-treated copper foil (control).

Table 10

| Foil | Adhesion (pounds/linear inch) |
|---|---|
| Zn/Cu | 4.0 |
| control | 1.0 |

Example 11

This example illustrates the improved adhesion obtained at temperatures above the melting point of zinc. The temperatures do not exceed the decomposition point of the fluoropolymer.

The procedure in Example 1 was repeated using a pressure of 300 psi. The results are given in Table 11.

Table 11

| | Adhesion (pounds/linear inch) | |
|---|---|---|
| | brass/Cu | control |
| 750 F (399 C) | 17.2 | 1.0 |
| 775 F (413 C) | 18.9 | 1.8 |
| 800 F (427 C) | (1) | 3.4 |
| 825 F (441 C) | (1) | 2.0 |
| 850 F (454 C) | (1) | 1.0 |

(1) The adhesion of these samples was so great that the copper fractured while trying to initiate the peel test.

**Claims**

1. A method for adhering a metal to a fluoropolymer employing an intermediate layer comprising contacting a layer of a metal selected from the group consisting of copper, aluminum and nickel, a layer of zinc or brass and a fluoropolymer layer which is selected from the group consisting of polytetrafluoroethylene, a copolymer of tetrafluoroethylene and hexafluoropropylene, a copolymer of tetrafluoroethylene and perfluoro(propyl vinyl ether), a copolymer of tetrafluoroethylene and perfluoro-2,2-dimethyl-1,2-dioxole, a terpolymer of tetrafluoroethylene, hexafluoropropylene and perfluoro(propyl vinyl ether), and a terpolymer of tetrafluoroethylene, hexafluoropropylene and perfluoro(ethyl vinyl ether), whereby the zinc or brass layer is between the fluoropolymer and the metal wherein a temperature in the range from the melting point of the fluoropolymer to below the decomposition temperature of the fluoropolymer is employed with the proviso that at least one of the following is obtained in accordance with Test Method No. 2.4.9, Revision A, Method B of the Institute for Interconnecting and Packaging Circuits:
    (i) a value of at least 3.0 pounds per linear inch or
    (ii) an increase in adhesion of at least 40 percent compared to an article formed in which the zinc or brass intermediate layer is eliminated and the metal is directly bonded by lamination onto the fluoropolymer.

2. The method of claim 1 wherein the metal is copper.
3. The method of claim 2 wherein the value in (i) is at least 5 pounds per linear inch.
4. The method of claim 2 wherein the value in (ii) is at least 300 percent.
5. The method of claim 2 wherein the conditions of both (i) and (ii) are present.
6. The method of claim 2 wherein the fluoropolymer is polytetrafluoroethylene and the temperature is at least 635° F.
7. The method of claim 6 wherein the value in (i) is at least 7.
8. The method of claim 2 wherein the fluoropolymer is a copolymer of tetrafluoroethylene and hexafluoropropylene and the temperature is at least 500° F.
9. The method of claim 8 wherein the value in (i) is at least 7.
10. The method of claim 2 wherein the fluoropolymer is a copolymer of tetrafluoroethylene and perfluoro(propyl vinyl ether) and the temperature is at least 575° F.
11. The method of claim 10 wherein the value in (i) is at least 7.
12. The method of claim 2 wherein the application is carried out in a lamination press.
13. The method of claim 12 wherein elevated pressure is applied and the pressure is at least 25 psi.
14. The method of claim 13 wherein the pressure is 300 psi.
15. The method of claim 2 wherein the application is carried out using a vacuum assembly.
16. The method of claim 15 wherein elevated pressure is applied and the pressure is at least 25 psi.
17. The method of claim 16 wherein the pressure is 300 psi.
18. The method of claim 1 wherein the intermediate zinc or brass layer is coated onto a metal foil prior to applying it to the fluoropolymer film such that in the application the zinc or brass coating is adjacent to the fluoropolymer.
19. The method of claim 1 wherein the metal is a foil.
20. The method of claim 1 wherein the temperature is below the melting point of the zinc or brass.
21. The method of claim 1 wherein the temperature is at or above the melting point of the zinc or brass.
22. A method for preparing a laminate comprising contacting at an elevated temperature in the range from the melting point of a fluoropolymer to below the decomposition temperature of the fluoropolymer a film of copper metal coated with zinc or brass, a polyimide supported fluoropolymer selected from the group consisting of polytetrafluoroethylene, a copolymer of tetrafluoroethylene and hexafluoropropylene, and a copolymer of tetrafluoroethylene and perfluoro(propyl vinyl ether), whereby the zinc or brass is adjacent to the fluoropolymer with the proviso at least one of the following is obtained in accordance with the Test Method No. 2.4.9, Revision A, Method B of the Institute for Interconnecting and Packaging Circuits:
    (i) a value of at least 5.0 pounds per linear inch or
    (ii) an increase in adhesion of at least 40 percent compared to an article formed in which the zinc or brass is eliminated and the copper is directly bonded by lamination onto the fluoropolymer.

23. An article comprising several layers suitable for use as a printed circuit board comprising in order (a) a fluoropolymer layer, which is selected from the group consisting of polytetrafluoroethylene, a copolymer of tetrafluoroethylene and hexafluoropropylene, a copolymer of tetrafluoroethylene and perfluoro-(propyl vinyl ether), a copolymer of tetrafluoroethylene and perfluoro-2,2-dimethyl-1,2,-dioxole, a terpolymer of tetrafluoroethylene, hexafluoropropylene and perfluoro(propyl vinyl ether), and a terpolymer of tetrafluoroethylene, hexafluoropropylene and perfluoro(ethyl vinyl ether),

(b) a layer of zinc or brass and

(c) a layer of metal selected from the group consisting of copper, aluminum and nickel

whereby layer (b) contacts and is intermediate layer (a) and layer (a) whereby the following adhesive is present in accordance with Test Method No. 2.4.9, Revision A, Method B of the Institute for Interconnecting and Packaging Circuits:

(i) a value of at least 3.0 pounds per linear inch or

(ii) an increase in adhesion of at least percent compared to an article formed in which the zinc or brass intermediate layer is eliminated and the metal is directly bonded by lamination onto the fluoropolymer.

24. The article of claim 23 wherein the metal of layer (c) is copper.

25. The article of claim 24 wherein values for both (i) and (ii) are present and wherein the value in (i) is at least 7 pounds per linear inch and the value in (ii) is at least 300 percent.